**Europäisches Patentamt**

**European Patent Office**

**Office européen des brevets**

(11) Veröffentlichungsnummer: **0 335 291**

**A2**

(12) # EUROPÄISCHE PATENTANMELDUNG

(21) Anmeldenummer: **89105351.4**

(22) Anmeldetag: **25.03.89**

(51) Int. Cl.⁴: **H01L 21/48 , H01L 21/68**

(30) Priorität: **31.03.88 DE 3810992**

(43) Veröffentlichungstag der Anmeldung:
**04.10.89 Patentblatt 89/40**

(84) Benannte Vertragsstaaten:
**DE FR GB IT**

(71) Anmelder: **Hoechst CeramTec
Aktiengesellschaft
Wilhelmstrasse 14
D-8672 Selb(DE)**

(72) Erfinder: **Röll, Rudolf
Tilchnerstrasse 9
D-8590 Marktredwitz(DE)**
Erfinder: **Brandenburger, Jürgen, Dr.
Prössberweg 23
D-8672 Selb(DE)**
Erfinder: **Hempel, Horst
Rosenstrasse 32
D-8590 Marktredwitz(DE)**

(74) Vertreter: **Reuter, Johann-Heinrich, Dr. et al
HOECHST AKTIENGESELLSCHAFT Zentrale
Patentabteilung Postfach 80 03 20
D-6230 Frankfurt/Main 80(DE)**

(54) **Verfahren und Vorrichtung zum Plattieren von Pin-Grid-Arrays.**

(57) Bei einem Verfahren zum Plattieren von Pin-Grid-Arrays (PGAs) werden die Pins des PGA's in einer Vorbiegevorrichtung vorgebogen und anschließend auf eine Aufnahmevorrichtung für PGAs aufgesteckt. Dabei wird ein elektrischer Kurzschluß über sämtliche Pins mittels runder oder keilförmiger Stäbe oder mittels Metallstifte, die zwischen mindestens zwei Pins geklemmt werden, hergestellt Die Metallstifte oder -stäbe sind auf einer möglichst rechtwinklig zu den Pins angeordneten Metallplatte befestigt. Die mit einem PGA bestückte Aufnahmevorrichtung wird an einem Galvanikgestell elektrisch leitend angebracht, mit der Kathode verbunden und in ein Galvanikbad getaucht. Nach der Metallabscheidung auf den kathodischen kontaktierten, elektrisch leitenden Flächen werden die Aufnahmevorrichtungen von dem Galvanikgestell gelöst und die plattierten PGAs abgezogen.

Eine Aufnahmevorrichtung für PGAs enthält eine rechteckige Grundplatte aus einem korrosionsbeständigen Metall, die mindestens ein Loch aufweist. Die Kantenlängen der Grundplatte haben mindestens die Abmessungen des PGA-Gehäuses. Auf der Metallgrundplatte sind Stäbe in äquidistanten Abständen parallel zur Oberfläche angeordnet und die Höhe der Stäbe über der Grundplatte beträgt mindestens die Hälfte der Pinlänge der PGAs . Der Abstand zwischen zwei Stäben auf der Oberfläche der Grundplatte entspricht dem doppelten Abstand zweier benachbarter Pinreihen auf dem PGA. Es sind mindestens soviele Stäbe vorhanden, daß alle Pins des PGA's kontaktiert werden.

FIG.3

## Verfahren und Vorrichtung zum Plattieren von Pin-Grid-Arrays

Die Erfindung betrifft ein Verfahren zum Plattieren von Pin-Grid-Arrays (PGAs) und einer Aufnahmevorrichtung für PGAs. Das erfindungsgemäße Verfahren beruht auf dem Einsatz dieser Aufnahmevorrichtung für PGAs, die so ausgelegt ist, daß zu plattierende PGAs aufgesteckt und sicher über sämtliche Pins kontaktiert werden können und im Galvanikbad gleichmäßig plattiert werden.

Seitdem die Integrationsdichte von Halbleiterschaltungen immer weiter gesteigert werden konnte, sind auch die Anforderungen an die Gehäuse, die solche Schaltungen aufnehmen, immer weiter gestiegen. So ist eine Verteilung von 225 und mehr Anschlüssen eines ca. 1 cm$^2$ großen Siliciumchips auf ebensoviele Kontaktstifte heute keine Seltenheit mehr. Die Leiterbahnführung vom Rande des Siliciumchips hin zu einem vorher festgelegten Anschlußpin auf dem Gehäuse ist z. B. mit der sogenannten Multilayertechnik möglich, bei der die Leiterbahnen in mehreren Ebenen übereinander, ggfs. mit Durchkontaktierungen, verlegt werden. Aufgrund der überlegenen Werkstoffeigenschaften von Keramik, insbesondere Al$_2$O$_3$-Keramik, werden solche Pin-Grid-Arrays heutzutage überwiegend aus diesem Werkstoff gefertigt. Die Fertigung dieser PGAs ist aufwendig, da sie mehrere hintereinandergeschaltete Arbeitsschritte umfaßt. Eine als "cofired Technik" bezeichnete Verfahrensweise zur Herstellung mehrlagiger keramischer Gehäuse ist beispielsweise beschrieben in der US 3 518 756.

Insbesondere bei PGAs, an die im späteren Einsatz sehr hohe Anforderungen gestellt werden, ist eine Vergoldung der sichtbaren, freiliegenden Leiterbahnen und der Anschlußpins unverzichtbar. Dieses Plattieren geschieht chemisch oder bevorzugt galvanisch. Eine große Gefahr bei diesem - meist letzten - Verfahrensschritt zur Herstellung eines PGA's besteht darin, daß einzelne Pins oder Teile von Leiterbahnen nicht richtig elektrisch kontaktiert werden und somit im galvanischen Bad nicht mit der gewünschten Goldschicht überzogen werden. Das Nachbeschichten ist verfahrenstechnisch sehr aufwendig und in der Regel zu teuer, so daß solche unvollständig plattierten PGAs - auch wenn es sich lediglich um einen einzigen Pin handelt - als Ausschuß betrachtet werden müssen. Ein Ausschuß im letzten Verfahrensschritt bedeutet aber andererseits - im Vergleich zu Ausschüssen in vorgelagerten Verfahrensschritten - eine unverhältnismäßig hohe Verteuerung der Produkte.

Zur galvanischen Abscheidung von Gold oder anderen Metallen aus entsprechenden Metallsalzbädern ist ein elektrischer Kontakt von allen zu plattierenden Flächen mit der Kathode erforderlich. Nach dem Stand der Technik erfolgt diese Kontaktierung über einen oder mehrere Kurzschlußringe, die in einer oder mehreren Lagen des Multilayer-PGA's angebracht sind und alle aufgedruckten Leiterbahnen dieser Schicht miteinander verbinden. Diese Kurzschlußringe sind nach außen geführt, wo sie dann elektrisch kontaktiert werden können. Mehrere solchermaßen kontaktierte PGAs werden dann an ein Galvanikgestell geklemmt, wobei ein elektrischer Kontakt zu dem Gestell, welches seinerseits direkt mit der Kathode verbunden ist, hergestellt wird und anschließend erfolgt dann die galvanische Metallabscheidung in einem Galvanikbad.

Der Kurzschlußring muß nach Abschluß der galvanischen Abscheidung entfernt werden. Dies kann z. B. durch Sägen oder vorheriges Kerben und Brechen erfolgen. Das nachträgliche Entfernen des Kurzschlußrings durch Trennen der gebrannten Keramik z. B. durch Sägen, Lasern, Wasserstrahlschneiden o. ä. ist sehr aufwendig und teuer. Das Kerben im ungebrannten Zustand mit Abbrechen des Kurzschlußrings nach dem Brennen und Vergolden ist zwar kostengünstiger, führt aber aufgrund der spröden Eigenschaften der Keramik zu undefinierten Bruchkanten und Schalenausbrüchen o. ä. und somit zu Ausfall. Ein Nacharbeiten der Kante ist wiederum sehr kostenintensiv.

Weiterhin ist nach dem Entfernen des Kurzschlußrings die austretende metallische Verbindung an der Seitenkante des PGA's immer sichtbar. Dies kann in den weiteren Verarbeitungsschritten, wie Aufbringen des Halbleiterchips, weitere galvanische Prozesse oder einem späteren Einsatz des fertigen elektronischen Bauteils, zu Kurzschlüssen führen.

Bedingt durch die Verbindung jeder einzelnen Leiterbahn nach außen zum Kurzschlußring vergrößert sich die zu metallisierende Fläche jeder Lage. Dies beeinflußt die elektrischen Kenndaten, z. B. die Kapazitäten. Bei den Gehäusen sind aber möglichst geringe Kapazitäten zwischen den einzelnen Lagen und zwischen den Leiterbahnen erwünscht, um eine gegenseitige Beeinflussung der Signalübertragung möglichst gering zu halten.

Bei der Konstruktion der Teile mit Kurzschlußring nimmt der flächenmäßige Anteil des Kurzschlußrings je nach Type und Ausführung 20 - 50 % der Fläche des Gehäuses ein. Die zusätzliche Fläche muß in allen Arbeitsschritten vom Beginn bis zum Vergolden mitgeschleppt werden, wobei die Produktionskapazität aller Arbeitsschritte, z. B. Aufdrucken der Leiterbahnen, Brennen der Gehäuse oder galvanische Metallabscheidung um diesen Prozentsatz gemindert wird, bzw. die Kosten erhöht werden.

Aus den obengenannten Gründen bestand die Aufgabe, ein Verfahren zum Plattieren von PGAs zu finden, welches ohne Kurzschlußring im PGA arbeitet und somit die obengenannten Nachteile ausschließt.

Dies wird beispielsweise dadurch erreicht, daß man den elektrischen Kontakt über die Pins (Kontaktstifte), die alle kurzgeschlossen werden, herstellt. In diesem Fall ist kein Kurzschlußring im PGA mehr erforderlich.

In der US 4,032,414 wird eine Vorrichtung zum Plattieren von zweireihigen Pin-Strips (z. B. Dual-in-line-Gehäuse) beschrieben. Dabei werden die Pin-Strips maschinell auf einen elektrisch leitenden Klemmstab aufgeklemmt und dann mittels eines Transportbandes durch verschiedene galvanische Bäder geführt und anschließend - ebenfalls maschinell - wieder von dem elektrisch leitenden Stab abgezogen. Selbst bei den beschriebenen zweireihigen Pin-Strips besteht aber die Gefahr, daß wenn ein oder mehrere Pins vor dem Aufstecken auf den Klemmstab nach außen gebogen sind, ein elektrischer Kontakt über alle Pins nicht gewähleistet ist. Diesen Nachteil versucht man in einer weiteren Ausgestaltung der Erfindung dadurch auszugleichen, daß die Doppel-Pin-Reihe nicht nur auf einen Klemmstab aufgedrückt wird, sondern daß zusätzlich zwei weitere Stäbe die beiden Pinreihen von außen auf den innen liegenden Klemmstab aufdrükken. Dazu ist jedoch eine weitere Vorrichtung mit einem Federmechanismus notwendig, die vor dem Aufstecken der Pin-Strips geöffnet werden muß und nachdem die Pin-Strips auf dem inneren Klemmstab positioniert sind, geschlossen werden muß, wobei die beiden Pin-Reihen gegen den inneren Klemmstab gedrückt werden. Der innere Klemmstab kann auch keilförmig sein.

Für das Plattieren von Pin-Grid-Arrays ist dieses Verfahren ungeeignet, da entweder ein sicherer Kontakt zu allen Pins nicht gewährleistet werden kann - was bei den wesentlich teureren Multilayer-PGAs von erheblichem Nachteil ist - oder aber die Vorrichtung, die ein sicheres Kontaktieren ermöglicht, konstruktiv zu aufwendig ist und somit das gesamte Verfahren unwirtschaftlich macht.

Die vorliegende Erfindung betrifft nun ein: Verfahren zum Plattieren von Pin-Grid-Arrays (PGAs), das dadurch gekennzeichnet ist, daß die Pins des PGA's in einer Vorbiegevorrichtung vorgebogen werden, anschließend auf eine Aufnahmevorrichtung für PGAs aufgesteckt werden, wobei ein Kurzschluß über sämtliche Pins mittels runder oder keilförmiger Stäbe oder mittels Metallstifte, die zwischen mindestens zwei Pins geklemmt werden, wobei die Metallstifte oder -stäbe auf einer möglichst rechtwinklig zu den Pins angeordneten Metallplatte befestigt sind, hergestellt wird, die mit einem PGA bestückte Aufnahmevorrichtung oder mehrere mit PGAs bestückte Aufnahmevorrichtungen an einem Galvanikgestell elektrisch leitend angebracht werden, das Galvanikgestell mit der Kathode verbunden wird und in ein Galvanikbad getaucht wird, wobei die Metallabscheidung auf den kathodisch kontaktierten, elektrisch leitenden Flächen stattfindet, und anschließend nach der Entnahme des Galvanikgestells aus dem Galvanikbad die Aufnahmevorrichtungen von dem Galvanikgestell gelöst werden und die plattierten PGAs von der Aufnahmevorrichtung abgezogen werden.

Weiterhin betrifft die Erfindung eine: Aufnahmevorrichtung für PGAs, die gekennzeichnet ist durch eine rechteckige Metallgrundplatte aus einem korrosionsbeständigen Material, wobei die Kantenlängen der Metallgrundplatte mindestens die Abmessungen des PGA-Gehäuses haben und wobei

a) auf der Metallgrundplatte Stäbe in äquidistanten Abständen parallel zur Oberfläche der Metallgrundplatte angeordnet sind und die Höhe der Stäbe über der Metallgrundplatte mindestens die Hälfte der Pinlänge der PGAs beträgt und der Querschnitt der Stäbe um 0 - 5 % größer ist als der Abstand zweier benachbarter Pinreihen auf dem PGA und der Abstand zwischen zwei Stäben auf der Oberfläche der Metallgrundplatte dem doppelten Abstand zweier benachbarter Pinreihen auf dem PGA entspricht und mindestens soviele Stäbe vorhanden sind, daß alle Pins des PGA's kontaktiert werden oder wobei

b) aus der Metallgrundplatte Metallstifte herausragen, deren Länge mindestens der Hälfte der Pinlänge der PGAs beträgt und deren Querschnitt zumindest im oberen Drittel 40 - 45 % größer ist als der Abstand zweier benachbarter Pinreihen auf dem PGA und der Abstand zwischen zwei benachbarten Stiften auf der Metallgrundplatte dem doppelten Abstand zweier benachbarter Pinreihen auf dem PGA entspricht und mindestens soviele Stifte vorhanden sind, daß alle Pins des PGA's kontaktiert werden und wobei die Metallgrundplatte sowohl in der Ausführung a) als auch in der Ausführung b) mindestens ein Loch aufweist.

Unter Plattieren wird die chemische oder galvanische Abscheidung von Metallen auf geeigneten Oberflächen verstanden. Bei dem erfindungsgemäßen Verfahren werden die Pins des PGA's beim Aufstecken auf die erfindungsgemäße Aufnahmevorrichtung kurzgeschlossen, so daß im Galvanikbad
- sämtliche Pins und
- sämtliche damit verbundenen freiliegenden Leiterbahnen mit einem Metallüberzug versehen werden.

PGAs, die mit dem erfindungsgemäßen Verfahren bei Verwendung der erfindungsgemäßen Aufnahmevorrichtung plattiert werden können, bestehen in der Regel aus einem einige Millimeter dik-

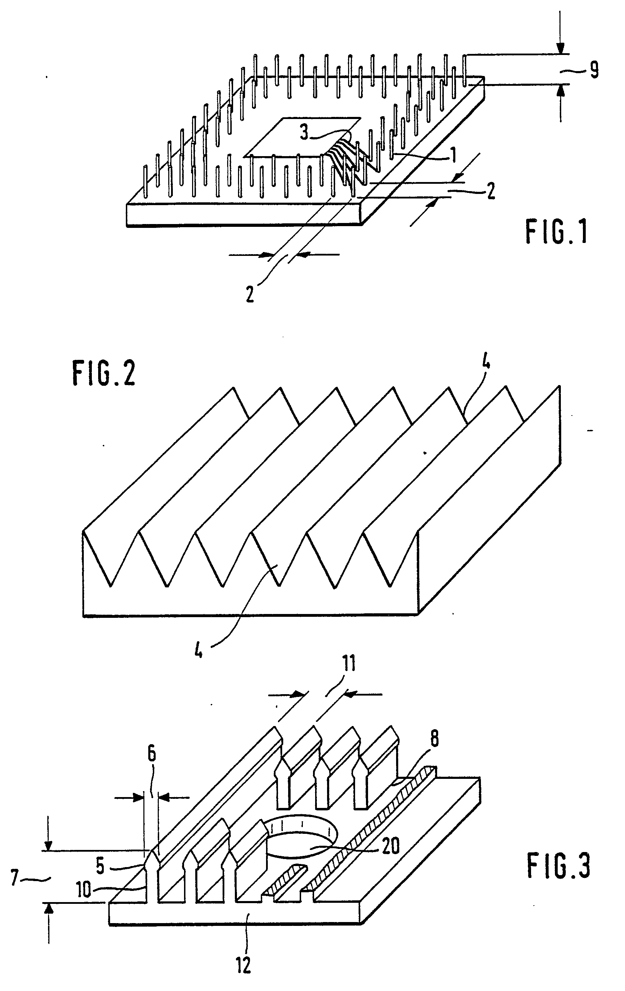

ken, rechteckigen Keramikgehäuse, auf dem auf einer Fläche parallel zu den Gehäusekanten Pins in äquidistanten Abständen angeordnet sind. Ein Ausführungsbeispiel eines solchen PGA's zeigt Figur 1. Hier sind parallel zu den Kanten 64 Anschlußpins (1) in Pin-Doppelreihen angebracht. Die Abstände zwischen zwei benachbarten Pins (2) - immer gemessen parallel zu den Kanten des Gehäuses - sind gleich. Größere PGAs besitzen 3,4 oder noch mehr parallel zu den Gehäusekanten angeordnete Pinreihen in äquidistanten Abständen. Die Leiterbahnen (3) verlaufen entweder auf der Gehäuseoberfläche (Slam-Version), auf der auch die Pins angebracht sind, oder aber auf Zwischenebenen des in Multilayertechnik hergestellten PGA's.

Die Pins bestehen meist aus Nickel/Eisen- oder Nickel/Eisen/Kobalt-Legierungen und sind biegsam. Diese Biegsamkeit wird ausgenutzt, um die Pins des PGA's vor dem Aufstecken auf die Aufnahmevorrichtung so vorzubiegen, daß sie eine Klemmwirkung auf die Stäbe oder Stifte der Aufnahmevorrichtung ausüben. Darüber hinaus hat das Vorbiegen der Pins den Vorteil, daß auch leicht deformierte Pins, die infolge von Nicht-Kontaktierung mit der Kathode zu einem Ausschuß-PGA führen würden - wieder in die richtige Richtung gebogen werden. Eine solche Vorbiegestation ist in Figur 2 gezeigt. Durch Eindrücken des PGA's in die sich v-förmig nach unten verjüngenden Rinnen (4) werden die Pinreihen gegeneinandergedrückt. Bevorzugt wird das PGA zweimal in die Vorbiegevorrichtung hineingedrückt, wobei beim zweiten Mal das PGA um 90° gedreht wird. Eine andere Möglichkeit besteht darin, zwei Vorbiegevorrichtungen hintereinander zu positionieren, die um 90° gegeneinander verdreht sind und das PGA nacheinander beide Stationen durchläuft.

Das dermaßen vorgebogene PGA kann nun auf die Aufnahmevorrichtung aufgesteckt werden, wobei ein sicherer Kontakt der Pins zu den Stäben oder Stiften der Aufnahmevorrichtung gewährleistet ist.

Die erfindungsgemäße Aufnahmevorrichtung besteht aus einer korrosionsbeständigen Metallgrundplatte, die vorzugsweise aus Titan oder V4A-Stahl gefertigt ist. Die Abmessungen dieser Metallgrundplatte in Länge und Breite sollten mindestens denen der PGA-Gehäuse entsprechen, vorteilhaft ist es, wenn die Länge und die Breite der Metallgrundplatte die der PGA-Gehäuse jeweils um 1 bis 4 mm überschreitet. Die Dicke der Platte ist unkritisch, sollte aber so bemessen sein, daß eine ausreichende mechanische Stabilität gewährleistet ist. Als zweckmäßig haben sich Dicken von 1 - 8 mm erwiesen.

Auf dieser Metallgrundplatte sind nun Metallstäbe - bevorzugt aus demselben Material wie die Metallgrundplatte - bevorzugt parallel zu zwei gegenüberliegenden Kanten der Metallgrundplatte angeordnet (s. Fig. 3). Diese Stäbe (5) können rund, bevorzugt jedoch keilförmig sein, wobei die Keilform der Stäbe so ausgeprägt ist, daß sich der Keil in lotrechter Richtung von der Metallgrundplatte (12) weg verjüngt; mit einer Spitze also über die Grundplatte hinausragt. Bei keilförmigen Stäben sollte die Keilbasis (6) - also die maximale vertikale Ausdehnung der Keile parallel zur Oberfläche der Metallgrundplatte - um 0 - 5 % größer sein als der Abstand (2) zweier benachbarter Pinreihen. Dadurch wird erreicht, daß die Pin-Doppelreihe beim Aufstecken des PGA's federnd auseinandergespreizt wird, was zu der erwünschten Klemmhaftung führt. Bei runden Stäben sollte der Querschnitt um 0 - 5 % größer sein als der Abstand zweier benachbarter Pinreihen. Die Höhe (7) der Metallstäbe über der Grundplatte sollte so bemessen sein, daß die Stäbe ausreichend weit in den Zwischenraum zwischen einer Pin-Doppelreihe hineinreichen, um eine gute Klemmwirkung zu erzielen. Als vorteilhaft hat es sich erwiesen, wenn die Höhe (7) der Metallstäbe - gemessen von der Unterkante (8) der Stäbe - über der Grundplatte mindestens die Hälfte der Pinlänge (9) des PGA's beträgt; bei den bevorzugt eingesetzten keilförmigen Stäben sollte die Keilbasis (6) mindestens auf einer Höhe über der Metallgrundplatte liegen, die der Hälfte der PGA-Pinlänge entspricht. Die Befestigung der Stäbe geschieht beispielsweise so, daß man die Stäbe fest mit Stegen (10) verbindet, die ihrerseits auf der Metallgrundplatte verankert sind. In einer bevorzugten Ausgestaltung der Erfindung werden die Stäbe (5) und Stege (10) einstückig aus der Metallgrundplatte herausgearbeitet. Der Abstand zweier Stäbe (11) voneinander - beispielsweise gemessen von der Keilspitze eines Stabes zur Keilspitze eines benachbarten Stabes - entspricht dem doppelten Abstand (2) einer Pin-Doppelreihe. Die Gesamtanzahl der auf der Oberfläche der Metallgrundplatte angeordneten Metallstäbe richtet sich nach der Anzahl der Pin-Doppelreihen auf einem PGA entlang bzw. senkrecht zu einer Kante des PGA's. Bei dem in Figur 1 dargestellten 64-Pin-Grid-Array benötigt man 5 Stäbe, um sämtliche Pins zu kontaktieren.

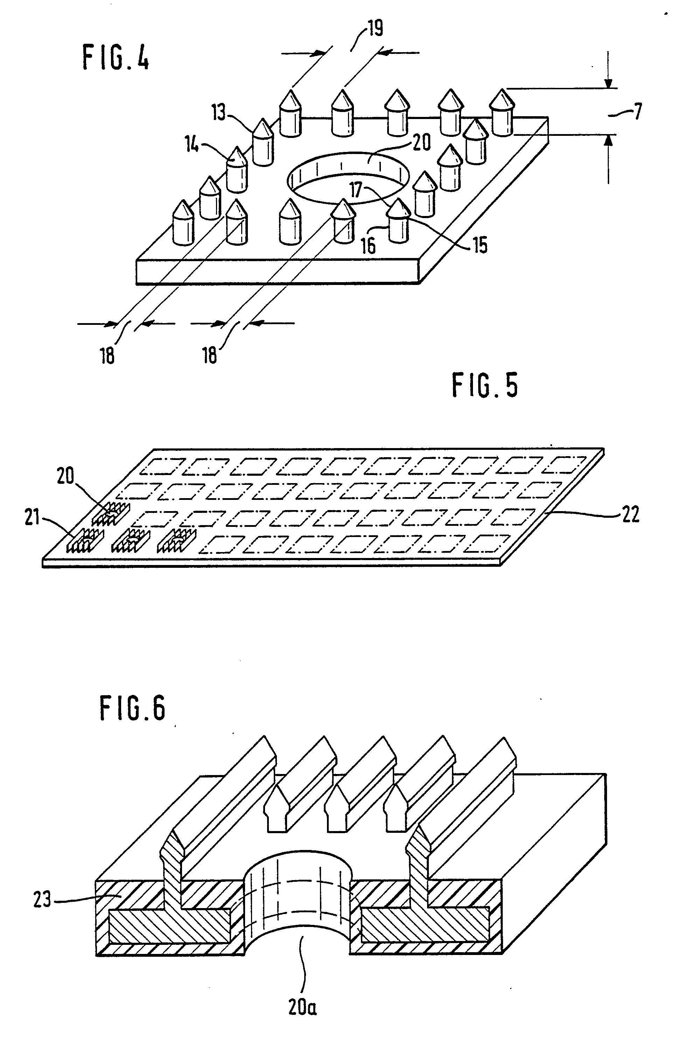

Bei einer anderen erfindungsgemäßen Ausgestaltung der Aufnahmevorrichtung ragen lotrecht aus der Metallgrundplatte Metallstifte heraus, die bevorzugt aus dem gleichen Material gefertigt sind wie die Metallgrundplatte. Die Stifte kontaktieren jeweils 4 Pins einer Pin-Doppelreihe (s. Figur 4). Die Metallstifte (13) können einen polygonalen, also beispielsweise 4-, 5-, 6-oder 7-eckigen Querschnitt haben oder einen runden Querschnitt. In einer bevorzugten Ausführung verjüngen sich die Stifte im oberen Drittel kegelförmig. Besonders bevorzugt sind die Metallstifte pilzartig geformt (15), d. h., sie bestehen aus einem unteren, zylinderförmigen Teil (16) und einem oberen, mit dem unteren Teil schlüssig verbundenen, kegelförmigen Teil (17). Hierbei ist der Querschnitt des unteren zylinderförmigen Teils kleiner als der Durchmesser des Kegelbasiskreises.

Die Höhe (7) der Metallstifte über der Grundplatte (12) sollte so bemessen sein, daß die Stifte ausreichend weit in den Zwischenraum zwischen 4 benachbarte Pins einer Pin-Doppelreihe hineinreichen, um eine gute Klemmwirkung zu erzielen. Als vorteilhaft hat sich erwiesen, wenn die Höhe (7) der Metallstifte über der Grundplatte (12) mindestens die Hälfte der Pinlänge des PGA's beträgt. Der maximale Querschnitt (18) der Metallstifte ist - zumindest im oberen Drittel der Stifte - um 40 - 45 % größer als der Abstand (2) zweier benachbarter Pinreihen. Der Abstand (19) zweier Stifte voneinander - beispielsweise gemessen von der Kegelspitze eines Stifts zur Kegelspitze des direkt benachbarten Stiftes - entspricht dem doppelten Abstand (2) einer Pin-Doppelreihe. Die Gesamtanzahl der auf der Oberfläche der Metallgrundplatte angeordneten Metallstifte richtet sich nach der Anzahl der Pin-Viererquadrate entlang der Pin-Doppelreihen auf einem PGA. Auf dem in Figur 1 dargestellten 64-PGA befinden sich 16 solcher Viererquadrate entlang der Kanten des PGA-Gehäuses, so daß auf der Aufnahmevorrichtung 16 Stifte entlang der Kanten angebracht werden müssen.

Steckt man nun ein zu plattierendes PGA auf eine solche Aufnahmevorrichtung auf - sei es auf eine solche gemäß Figur 3 oder Figure 4 - und taucht die Vorrichtung - nachdem sie mit der Kathode verbunden wurde - samt PGA so in ein Galvanikbad, daß die unbestückte Seite der Metallgrundplatte in Richtung der Anode zeigt, so müssen bei Stromfluß die Metallionen um die Metallgrundplatte herumwandern, um auf den kathodisch kontaktierten Flächen des PGA's abgeschieden werden zu können. Dies kann zu unerwünschten, unterschiedlichen Metallschichtdicken auf den äußeren plattierten Flächen einerseits und auf den inneren plattierten Flächen andererseits führen. Dieses sog. "Shielding" der Metallgrundplatte kann beispielsweise dadurch beeinflußt werden, daß man die Grundplatte (12) durchlöchert, bevorzugt wird durch das Zentrum der Grundplatte (12) ein Loch (20) gebohrt, so daß die Wanderung der Metallionen zu den innen gelegenen Flächen des PGA's erleichtert wird. Durch geeignete Wahl der Lochgröße kann dafür Sorge getragen werden, daß die Metallschichtdicke auf allen plattierten Flächen des PGA's nahezu konstant ist. Die Bestimmung der idealen Lochgröße kann durch einfache Reihenversuche mit unterschiedlichen Lochdurchmessern erfolgen.

Um eine unnötige und unerwünschte Abscheidung der meist recht teuren Metalle auf der metallischen Grundplatte zu verhindern, wird die gesamte Metallgrundplatte einschließlich der unteren Teile der Stege bzw. Metallstifte mit einem Schutzüberzug versehen, der inert gegenüber den in der Galvanik verwendeten Chemikalien ist. Als Material für den Schutzüberzug kann beispielsweise Silikonkautschuk oder ein geeigneter Lack verwendet werden. Zweckmäßigerweise werden die Stege bzw. Stifte bis zu 50 % ihrer Höhe mit dem Schutzüberzug versehen, der darüber hinausstehende Rest bleibt frei.

In einer weiteren Ausgestaltung der Erfindung werden mehrere der oben beschriebenen Aufnahmevorrichtungen zu einer größeren Platte, die mehrere PGAs aufnehmen kann, zusammengefügt. Dies kann beispielsweise durch Verknüpfung mehrerer Aufnahmevorrichtungen über die gemeinsamen Kanten erfolgen. Figur 5 zeigt eine solche Multiaufnahmevorrichtung, bei der 40 Einzelaufnahmevorrichtungen (21) gemäß Fig. 3 in einem Raster von 10 x 4 miteinander verbunden sind. Selbstverständlich kann eine solche Multiaufnahmevorrichtung (22) auch einstückig hergestellt werden, ohne daß Einzelaufnahmevorrichtungen zusammengefügt werden müssen.

Bei der Herstellung der Aufnahmevorrichtungen geht man am besten so vor, daß man entweder aus einer massiven Metallgrundplatte die Stäbe einschließlich der Stege beispielsweise durch Erodieren herausarbeitet oder in eine massive Grundplatte Löcher mit den erforderlichen Abmessungen für die Stifte hineinbohrt und die Metallstifte dann in diesen Löchern nach bekannten Methoden befestigt. Die Löcher zur Beeinflussung des Shieldings werden durch die Metallgrundplatte gebohrt. In gleicher Weise kann man auch bei der Herstellung der Multiaufnahmevorrichtung verfahren.

Der Schutzüberzug kann beispielsweise bei Verwendung eines Silikonkautschuks (Wacker, RTV 533) durch Gießen in einer Form, in der sich die Aufnahmevorrichtung befindet, erfolgen, wobei die flüssige Silikonkautschukmasse bis zur gewünschten Höhe der Stege bzw. Stifte - also so, daß nur noch ein Teil unbedeckt bleibt - in die Form gefüllt wird.

Diese Vorgehensweise hat den Vorteil, daß man den Lochdurchmesser, der das Shielding beeinflußt, verkleinern kann, beispielsweise dadurch, daß man an die Stelle in der Gießform, auf die die Aufnahmevorrichtung mit ihrem Shielding-Loch gelegt wird und an der nachher ein Loch definierter kleinerer Größe (20a) (s. Fig. 6) aus dem Schutzüberzug ausgespart sein soll, einen zylinderförmigen Bolzen setzt, um den die Kautschukmasse sich herumlegt. Ein Ausschnitt aus einer solchen mit Silikonkautschuk (23) überzogenen Multiaufnahmevorrichtung ist in Fig. 6 gezeigt. Hier hat das aus dem Silikonkautschuk ausgesparte Loch (20a) einen kleineren Durchmesser als in der Metallgrundplatte.

Bei dem Verfahren zum Plattieren von PGAs geht man am besten so vor, daß man die zu plattierenden PGAs in einer Vorbiegestation mit einer Vorbiegevorrichtung, beispielsweise einer solchen gemäß Figur 2, vorbiegt.

Zweckmäßigerweise wird das PGA mit seinen Pins entweder zweimal hintereinander in die gleich positionierte Vorbiegeeinrichtung hineingedrückt, wobei das PGA beim zweiten Mal um 90° verhreht (um die Mittelpunktachse, die senkrecht auf der größten Oberfläche des PGA's steht) hineingedrückt wird oder man positioniert zwei Vorbiegevorrichtungen so hintereinander, daß deren v-förmige Rinnen um 90° gegeneinander verdreht sind und drückt dann das PGA nacheinander in die beiden Vorbiegevorrichtungen. Im Anschluß daran werden die PGAs auf die erfindungsgemäßen Aufnahmevorrichtungen geklemmt, wobei mittels der auf der Metallgrundplatte angeordneten Metallstäbe oder -stifte ein Kurzschluß über sämtliche auf dem PGA befindlichen Pins hergestellt wird. Die so bestückten Aufnahmevorrichtungen werden nun elektrisch leitend an einem Galvanikgestell befestigt, auf dem mehrere solcher Aufnahmevorrichtungen Platz haben. Nach Kontaktierung des Galvanikgestells mit der Kathode und Eintauchen des Gestells in ein Galvanikbad erfolgt die Metallabscheidung nach bekannten Methoden. Nach der Entnahme der Galvanikgestelle aus dem Galvanikbad und nach Abspülung und Trocknung werden die Aufnahmevorrichtungen von dem Galvanikgestell gelöst und die plattierten PGAs von den Aufnahmevorrichtungen abgezogen.

Insbesondere die Multiaufnahmevorrichtungen eignen sich zur Teilautomatisierung des Galvinisierprozesses. So lassen sich das Vorbiegen der PGAs, das Be- und das Entstücken der Multiaufnahmevorrichtungen besonders gut maschinell durchführen, was zu einer weiteren Reduzierung der Ausschußquote führt, da insbesondere ein Verkanten der PGAs beim Vorbiegen und Be- und Entstücken fast völlig ausgeschlossen ist.

**Ansprüche**

1. Verfahren zum Plattieren von Pin-Grid-Arrays (PGAs), dadurch gekennzeichnet, daß die Pins des PGA's in einer Vorbiegevorrichtung vorgebogen werden, anschließend auf eine Aufnahmevorrichtung für PGAs aufgesteckt werden, wobei ein Kurzschluß über sämtliche Pins mittels runder oder keilförmiger Stäbe oder mittels Metallstifte, die zwischen mindestens zwei Pins geklemmt werden, wobei die Metallstifte oder -stäbe auf einer möglichst rechtwinklig zu den Pins angeordneten Metallplatte befestigt sind, hergestellt wird, die mit einem PGA bestückte Aufnahmevorrichtung oder mehrere mit PGAs bestückte Aufnahmevorrichtungen an einem Galvanikgestell elektrisch leitend angebracht werden, das Galvanikgestell mit der Kathode verbunden wird und in ein Galvanikbad getaucht wird, wobei die Metallabscheidung auf den kathodisch kontaktierten, elektrisch leitenden Flächen stattfindet und anschließend nach der Entnahme des Galvanikgestells aus dem Galvanikbad die Aufnahmevorrichtungen von dem Galvanikgestell gelöst werden und die plattierten PGAs von der Aufnahmevorrichtung abgezogen werden.

2. Verfahren nach Anspruch 1, dadurch gekennzeichnet, daß das Vorbiegen der Pins des PGA's, die Bestückung der Aufnahmevorrichtungen mit PGAs und die Entstückung in einem automatisierten Prozeß erfolgt.

3. Aufnahmevorrichtung für PGAs, gekennzeichnet durch eine rechteckige Metallgrundplatte aus einem korrosionsbeständigen Material, deren Länge und Breite mindestens so groß wie Länge und Breite eines PGA-Gehäuses sind, und die mehrere regelmäßig angeordnete metallene Vorsprünge, an denen sämtliche Pins eines PGA festgeklemmt werden können, sowie mindestens ein Loch aufweist.

4. Vorrichtung gemäß Anspruch 3, dadurch gekennzeichnet, daß auf der Metallgrundplatte mehrere Metallstäbe in parallelen Reihen parallel zur Oberfläche der Metallgrundplatte angeordnet sind und die Höhe der Stäbe über der Metallgrundplatte mindestens die Hälfte der Pinlänge der PGAs beträgt und der Querschnitt der Stäbe um 0 - 5 % größer ist als der Abstand zweier benachbarter Pinreihen auf dem PGA und der Abstand zwischen zwei Stäben auf der Oberfläche der Metallgrundplatte dem doppelten Abstand zweier benachbarter Pinreihen auf dem PGA entspricht und mindestens soviele Stäbe vorhanden sind, daß alle Pins des PGA's kontaktiert werden.

5. Vorrichtung gemäß Anspruch 3, dadurch gekennzeichnet, daß aus der Metallgrundplatte Metallstifte herausragen, deren Länge mindestens der Hälfte der Pinlänge der PGAs beträgt und deren Querschnitt zumindest im oberen Drittel 40 - 45 % größer ist als der Abstand zweier benachbarter Pinreihen auf dem PGA und der Abstand zwischen zwei benachbarten Stiften auf der Metallgrundplatte dem doppelten Abstand zweier benachbarter Pinreihen auf dem PGA entspricht und mindestens soviele Stifte vorhanden sind, daß alle Pins des PGA's kontaktiert werden

6. Vorrichtung nach Anspruch 4, dadurch gekennzeichnet, daß die Stäbe einen Querschnitt in Form eines Keils besitzen, der sich in lotrechter Richtung von der Grundplatte weg verjüngt.

7. Vorrichtung nach Anspruch 4, dadurch gekennzeichnet, daß die Stäbe auf Stegen sitzen.

8. Vorrichtung nach Anspruch 7, dadurch gekennzeichnet, daß Stäbe und Stege einstückig sind und aus der Grundplatte herausgearbeitet sind.

9. Vorrichtung nach Anspruch 4, dadurch gekennzeichnet, daß die Stäbe parallel zu zwei gegenüberliegenden Kanten der rechteckigen Metallgrundplatte ausgerichtet sind.

10. Vorrichtung nach Anspruch 5, dadurch gekennzeichnet, daß die Metallstifte einen runden Querschnitt haben.

11. Vorrichtung nach Anspruch 10, dadurch gekennzeichnet, daß die runden Metallstifte sich im oberen Drittel kegelförmig verjüngen.

12. Vorrichtung nach Anspruch 11, dadurch gekennzeichnet, daß der sich verjüngende Kegel des Metallstifts an der breitesten Stelle breiter ist als an der Basis des Metallstifts.

13. Vorrichtung nach Anspruch 3, dadurch gekennzeichnet, daß die Metallgrundplatte und die Stäbe und Stege oder Stifte einheitlich aus Titan oder V4A-Stahl gefertigt sind.

14. Vorrichtung nach Anspruch 3, dadurch gekennzeichnet, daß mehrere Metallgrundplatten (Einzelgrundplatten) mechanisch so zu einer größeren Metallplatte verbunden sind, daß die seitlichen Begrenzungsflächen der Einzelgrundplatten einander berühren.

15. Vorrichtung nach Anspruch 14, dadurch gekennzeichnet, daß 40 Einzelgrundplatten in einem Raster von 4 x 10 zu einer großen Metallgrundplatte verbunden sind.

16. Vorrichtung nach Anspruch 14, dadurch gekennzeichnet, daß die einzelnen Metallgrundplatten auf ein Metallgestell gesteckt sind.

17. Vorrichtung nach Anspruch 14, dadurch gekennzeichnet, daß die Löcher der Einzelgrundplatten umso größer sind, je weiter die Einzelgrundplatten in der Mitte der großen Metallplatte angeordnet sind.

.18. Vorrichtung nach Anspruch 3, dadurch gekennzeichnet, daß eine einzelne Metallgrundplatte oder die gesamte aus mehreren Einzelgrundplatten aufgebaute große Metallgrundplatte bis zu 50 % der Steghöhe bzw. 50 % der Stifthöhe mit einem haftenden Schutzüberzug. versehen ist, der inert gegenüber den in der Galvanik verwendeten Chemikalien ist.

19. Vorrichtung nach Anspruch 18, dadurch gekennzeichnet, daß der Schutzüberzug aus Silikonkautschuk besteht.

FIG.1

FIG.2

FIG.3

FIG.4

FIG.5

FIG.6